Europäisches Patentamt

**European Patent Office**

**Office européen des brevets**

(11) Publication number: **0 165 031 B1**

# EUROPEAN PATENT SPECIFICATION

(45) Date of publication of patent specification: **29.01.92** (51) Int. Cl.⁵: **G03F 3/10**

(21) Application number: **85304065.7**

(22) Date of filing: **07.06.85**

---

(54) **Presensitized color-proofing sheet.**

---

(30) Priority: **11.06.84 US 619000**

(43) Date of publication of application:
**18.12.85 Bulletin 85/51**

(45) Publication of the grant of the patent:
**29.01.92 Bulletin 92/05**

(84) Designated Contracting States:
**DE FR GB SE**

(56) References cited:
**EP-A- 0 115 899      DE-A- 1 912 864**
**FR-A- 2 549 976      US-A- 4 260 673**
**US-A- 4 304 836      US-A- 4 366 223**

(73) Proprietor: **MINNESOTA MINING AND MANU-
FACTURING COMPANY
3M Center
St. Paul, Minnesota 55101(US)**

(72) Inventor: **Cederberg, Barbara M. c/o Minne-
sota Mining and
Manufacturing Comp. 2501 Hudson Road
P.O.Box 33427
St. Paul Minnesota 55133(US)**
Inventor: **Musser, Arlene K. c/o Minnesota
Mining and
Manufacturing Comp. 2501 Hudson Road
P.O.Box 33427
St. Paul Minnesota 55133(US)**

(74) Representative: **Bowman, Paul Alan et al
LLOYD WISE, TREGEAR & CO. Norman
House 105-109 Strand
London WC2R OAE(GB)**

## Description

### 1. Field Of The Invention

The present invention relates to the photo-mechanical production of multi-color images on a single sheet or substrate without printing. The invention has particular application in the proofing of color separation negatives preparatory to multi-color lithographic reproduction.

### 2. Description Of The Prior Art

In printing pictoral matter, whether by lithography, letterpress or gravure, the half tone process is used, wherein the actual printing image is composed of thousands of minute dots per square inch of a single color ink of varied dot size or ink density. What the naked eye sees as shading in half tone prints is actually a controlled variation in the size of dots relative to the unprinted areas between the dots. In black and white pictorial matter the dots are printed in black ink only. Full color reproductions, however, are necessarily printed in each of at least three colors, cyan, magenta, and yellow (known as "three color process"), or in these same colors with the addition of black ("four color process"). For each color a printing plate is made. In order to make the three or four printing plates, the original color picture or photograph is "separated" photographically, with the use of filters, masks, etc., into a set of three or four half-tone negatives, each representing one of the colors, and containing, dot for dot, the amount of that color which must be printed to produce the desired total color print.

The preparation of the color-separation negative is an art and requires considerable skill in handling the many variables to produce a desired result. Often trial and error is involved requiring correction or replacement of one or more of the negatives. Unless some reliable system is available to "proof" the negatives, the printing press must be set up and copy printed just to secure preliminary proofs. This is time consuming and expensive. It is therefore desireable to provide accurate means for proofing the negatives without printing.

One system for proofing color separation negatives is disclosed in U.S. Pat. No. 3,136,637. A light-sensitive transparent sheet is provided for each of the colors to be printed. Each of the sheets is exposed through its respective color separation negative. Upon processing, the color in the non-image areas is removed, yielding a sheet which contains the desired color pattern in the image areas, while being colorless and transparent in the non-image areas (e.g. between halftone dots). After each of the separate sheets is made, they are assembled together in registry on a white background, whereupon a color proof results.

That system of color proofing has a number of inherent drawbacks. For example, the laying up of the multiplicity of sheets requires that the viewer look through a plurality (three or four) of transparent films during the proofing operation. Since the composite is made of several separate sheets, extreme care is required to maintain registry. If the individual sheets are not perfectly colorless and transparent in the optical sense, any "haze" or imperfection present is multiplied in the several sheets. Additionally, incident light reflects from the several sheets imparting a gloss which is not truly representative of printed copy, thus introducing a need for interpretation in evaluating the proof.

U.S. Patent 3,671,236 improves upon the proofing system described in U.S. Patent 3,136,637. Photo-mechanically produced images corresponding with each color are integrally built up on a single substrate (much as occurs in the actual printing operation itself) without any printing operations. The multiplicity of carrier films is eliminated by transferring individual color images from a sheet comprised of 1) a carrier with release surface, 2) pigment and binder layer, 3) photohardenable or insolubilizable layer, 4) barrier layer and 5) pressure-sensitive adhesive layer.

A diazo oxide based color proofing system is disclosed in U.S. Patent No. 4,260,673 in which a presensitized color proofing sheet comprises a carrier sheet having a smooth release surface;

a color coating of a diazo oxide and a pigmented resin compound in clinging engagement with but not adhesively bonded to said release surface of said carrier sheet; a binder layer comprising a mixture or reaction product of a resin and a diazo oxide bonded to the surface of said color coating; said binder layer being free of color pigment; and said color coating and said binder layer being solubilizable in a solvent developing medium upon exposure to actinic radiation but not solubilizable in the developing medium prior to exposure to actinic radiation; and

a clear barrier layer firmly attached to said binder layer, said barrier layer being insoluble in said solvent development medium. The barrier layer generally comprises a heat activated adhesive although a pressure-sensitive adhesive may be applied over the barrier layer.

The present invention relates to a photo-sensitive article particularly useful in the generation of photo-mechanical proofs which comprises a carrier with a release surface, a pigment and binder layer, a photohardenable layer, an organic polymeric solvent insoluble barrier layer, and a thermally laminable adhesive layer.

In particular the invention provides a presensitizied color-proofing sheet comprising:

a carrier sheet having a smooth release surface;

a continuous color coating comprising a layer of a pigmented resinous polymer in clinging engagement with, but not adhesively bonded to the release surface;

a layer of a light-sensitive diazo resin in direct association with the color coating, and

a layer of a thermally-activated adhesive, which sheet is characterised by the combination of:

(a) being negative acting wherein the color coating comprises a pigmented, organophilic, hydrophobic, water-insoluble, resinous polymer softenable and/or partially dissolvable in a solvent developing medium,

(b) having a continuous, water-insoluble, transparent, colorless barrier layer interposed between the diazo resin layer and the thermally-activated adhesive layer, the barrier layer being insoluble in the solvent developing medium,

the diazo resin being directly associated with the color coating either (i) by being incorporated in the color coating to form a single layer, or (ii) by being incorporated in a separate but contiguous layer from the color coating layer, and being soluble in the solvent developing medium, such that the diazo resin becomes insolubilized and firmly bonds the color layer to the barrier layer in the light struck areas upon light exposure of the sheet, the color layer and diazo resin being readily removable from the barrier layer in areas not light exposed, and

(c) the thermally activated adhesive layer comprises a layer of at least one acrylic polymer or copolymer which is laminable at a temperature between 100 and 150°C at a pressure of $0.29 \text{ kg/cm}^2$ in 10 seconds, non-tacky at room temperature, will not discolor or alter its optical density by as much as 0.05 optical density units when exposed to 5 kilowatts of ultraviolet radiation at 417 nanometers at a distance of 10 cm for 2 minutes or during imaging, and having no ingredients capable of migrating through the barrier layer and desensitizing the diazo resin, discoloring the pigment, or distorting the optical properties of the other layers.

The use of a thermally laminable adhesive layer rather than a pressure-sensitive adhesive layer offers the opportunity for some advantages. A thermally adhesive layer can be positioned and repositioned (before lamination) without altering the receptor surface or picking up extraneous matter which can occur with pressure-sensitive adhesive layers. The physical nature of the smooth, transparent and optically clear thermally laminable adhesive layer offers better optical qualities than the less physically smooth pressure-sensitive adhesive layer.

In attempting to substitute a thermally laminable adhesive layer for the pressure-sensitive adhesive layer of U.S. Patent No. 3,671,236, significant problems were encountered. Amongst the problems encountered were 1) yellowing of the adhesive layer when exposed to actinic radiation, particularly ultraviolet radiation, during imaging of the proof, 2) self-lamination of thermal adhesive during storage at 45°C and $2 \text{ grams/cm}^2$ pressure, 3) excessive laminating temperatures which deteriorated the sensitometric properties of the photohardenable layer, 4) and ingredients in the thermal adhesive layer that were fugitive and migrated through the barrier layer to disturb the sensitometry of the photohardenable layer, the color of the pigment containing layer and the optical properties of other layers. Many adhesives also would not adhere to the receptor sheet or the barrier layer.

It has been found critical to the use of the thermally laminable adhesive layer in the photo-mechanical proofing article of the present invention that the following properties be provided by the thermal adhesive layer:

1) the adhesive layer be thermally laminable at a temperature between 100 and 150°C at a pressure of $1.6 \text{ lb/in}^2$ ($.29 \text{ kg/cm}^2$),

2) the adhesive layer is non-tacky at room temperature or preferably not laminable to paper or self-laminable at 45°C, $2 \text{ g/cm}^2$, for at least one week,

3) will not discolor or alter its optical density by more than 0.05 optical density units when exposed to 5 kilowatts of ultraviolet radiation of wavelength at 417 nanometers, at a distance of 10cm for 2 minutes, and

4) have no ingredients which by themselves or in combination with the solvent of the adhesive layer migrate across the barrier layer and desensitize the photohardenable layer, alter the color or tone of the pigments, or alter the optical qualities of the barrier or photosensitive layer.

The adhesive layer must also strongly adhere to the barrier layer, the bond strength between those layers exceeding the mild bond strength between the release layer and either the pigment containing binder layer or the carrier layer.

The construction according to the present invention would typically comprise a carrier sheet provided with a release surface, which may either be a smooth surface of the carrier itself, or a surface coating thereon. Overlying the surface and in intimate clinging engagement therewith, but not adhesively bonded thereto, is a color coating comprising, for example, a pigmented organophilic water-insoluble solvent-softenable resinous polymer. Coated over and in contact with the color-coating is a light-sensitive diazo resin layer. The color coating and light-sensitive layer are intimately associated and adherently bonded together (and in certain constructions can actually be combined to a single layer). The light-sensitive layer is soluble in a solution which softens and/or partially dissolves the color coating.

Overlying the light-sensitive layer is a continuous solvent-resistant resinous protective film or barrier layer. To the exposed surface of the barrier layer is applied a layer of thermally laminable adhesive. Preferably the adhesive layer is from $0.1 \times 10^{-4}$ cm to $20 \times 10^{-4}$ cm in thickness. The outer surface of the adhesive can optionally be protected from contamination by dirt or grease, by a protective release liner.

In applying that structure to a substrate, such as white paper, the protective liner is first stripped from the adhesive surface and the entire structure is laminated for example, by heated rolling, onto the substrate. Thereafter, the carrier sheet is stripped from the structure, the bond to the paper and the adhesion between the several layers being greater than the non-adhesive clinging engagement between the carrier sheet and the color coating or the release layer. Following the removal of the carrier, the remaining structure, now bonded to the substrate, is exposed to ultraviolet light through the appropriate color separation negative corresponding with the color of the particular coating. In the light struck areas, the ultraviolet light passes through the color coating (which is transparent thereto) and exposes and insolubilizes the light--sensitive material. A firm bond between the light reacted material and the under-and over-lapping coatings occurs. Adjacent unexposed areas remain light-sensitive.

Thereafter the sheet is processed with processing solvent selected with respect to the particular material of which the color coating layer is composed (and which contains a solvent for the unexposed diazo), to develop the image. The color coating and the sensitizer in the non-light struck areas is removed, leaving the color image anchored to the underlying barrier layer by the light-reacted diazo in exposed areas. During processing, the barrier layer serves as a barrier which protects the substrate (and adhesive) from solutions used during the processing.

The adhesive system of the present invention has been found to be limited to a narrow class of available thermal adhesives. Only acrylate polymer and copolymer thermal adhesives with a laminating temperature of 100 to 150°C at a pressure of 0.29 kg/cm$^2$ for 5-10 seconds have been found to fulfill all requirements of the present invention. Polymers of n-butyl acrylate, ethyl acrylate, isopropyl acrylate and their copolymers with ethylenically unsaturated monomers such as other acrylates, acrylic anhydride, acrylic acid, methacrylic acid, styrene, vinyl acetate, and the like are the only adhesives that fulfill all essential requirements of the present invention. Monomers which cause yellowing or discoloring of the final adhesive composition when it is exposed to 5 kw radiation at 417 nm at 10 cm for two minutes must be avoided. Any change in the optical density of 0.1 and even 0.05 is considered intolerable discoloration. Copolymerizable ethylenically unsaturated materials such as acrylonitrile, vinylidene chloride, and vinyl chloride tend to cause yellowing and must be used, if used at all in amount less than 10% and preferably less than 5% of the total dry weight of components in the adhesive. Prefered compositions include poly (n-butyl acrylate/ethyl acrylte) (60/40), poly (ethyl acrylate/styrene) (64/36), poly (n-butylacrylate), poly (styrene/n-butylacrylate/acrylic acid/acrylonitrile) (45/45/8/2), and poly (n-butyl acrylate/vinyl acetate) (80/20).

Many other thermal adhesive systems were attempted, but all others failed for various reasons.

Following the above described photomechanical production of the first color image on the substrate, for example cyan (blue), similar sheets but containing the yellow, magenta and black color coatings are successively applied to yield a four color proof.

These and other aspects of the invention will now be illustrated in the following non-limiting examples:

EXAMPLES 1-13

A 2-mil film of smooth-surfaced biaxially oriented polyethylene terephthalate polyester is first coated with a polyvinyl alcohol solution constituted as follows:

| | Parts by wt. |
|---|---|
| Polyvinyl alcohol (available commercially as Gelvatol 20-30/Gelvatol 20:90 (3/1)) | 2.5 |
| Glycerin | 0.5 |
| Water | 97 |

A dry coating weight of 75 mg./ft.$^2$ provides a satisfactory release layer. The release layer surface is oven dried and then overcoated with a resin solution containing a suitable transparent pigment, in this instance a phthalocyanine pigment, e.g. "Monastral Blue BT 284-D."

The coating solution is prepared by first dispersing the pigment into 1,1,2-trichloroethane solvent, and adding polyvinylformal resin (Formvar 15/95 E), the amount of the ingredients being adjusted to yield a mix having 65 parts resin, 35 parts pigment, and 900 parts solvent. This mix is appropriately milled. The resultant mill base is then diluted by adding further solvent to yield approximately a 3 percent solids. This pigmented-resin coating solution or dispersion is applied over the dried release layer at a dry coating weight of about 50-70 milligrams per square foot. The coated sheet construction is oven dried as before to evaporate the solvent.

The polyvinyl formal coated side of the sheet is then primed by a corona discharge treatment, sufficient to render the surface of the film water-wettable.

A solution of a light-sensitive diazo resin or equivalent is then coated over the primed surface of the sheet. A preferred diazo resin is the condensation product of p-diazodiphenylamine and formaldehyde, prepared, for example, in accordance with the method described in U.S. Pat. No. 2,714,066. A solution of the pure diazo resin, for example, 4 parts resin dissolved in 48 parts water and 12 parts methanol, is made up.

The preparations of the light-sensitive diazo resin are carried out under subdued light, for example, under a yellow light. This is also true of the other operations involving the coating of the sheet with the light-sensitive resin and subsequent handling of the sensitized sheet prior to exposure and development.

The solution of the light-sensitive diazo resin just described may be applied over the primed polyvinylformal layer by roll-coating or by dipping the sheet into the solution of the resin. It is preferred that the diazo coating be thin, a residue of about 6-8 milligrams of the diazo resin per square foot of area being satisfactory, although the precise amount is not particularly critical with amounts of 3-50 mg./ft.$^2$ being useful. The sheet is then air dried at room temperature, or at slightly elevated temperatures if desired. A barrier is applied over the diazo layer, for example, by coating a two percent weight solution in methyl ethyl ketone of a 3:1 weight ratio of poly acrylate ("Elvacite 2044") and a polyvinyl chloride-acetate copolymer ("Vinylite VAGH") at a dry coating weight of 160 mg./ft.$^2$ (generally a coating weight of 100 - 400 mg/ft$^2$ is prefered).

A clear colorless thermally laminable adhesive is coated on the acrylate surface at a dry coating weight of 800 mg./ft.$^2$. Following drying, a protective liner of polyethylene coated paper is not necessary but may be placed against the adhesive to facilitate handling of the sheet and to protect the adhesive from dirt, etc. In this form the light--sensitive sheet can then be converted into standard sizes, packed in suitable light-proof containers and shipped in commerce. The adhesive may be coated in much greater quantities, a general range being from about 100 to 1200 mg./ft.$^2$.

The following resins were tried as the thermal laminating adhesive with two different laminating temperatures used (110 and 140ºC) with the results indicated in the table:

5

| Example | Adhesive | Comments/Results |
|---|---|---|
| 1. | Poly(n-butyl acrylate) | A clear faithful proof rendition |
| 2. | Poly(n-butylacrylate/ethylacrylate) (60/40) | A clear faithful proof rendition |
| 3. | Poly(styrene/ethylacrylate) (36/64) | A clear faithful proof rendition |
| 4. | Poly(styrene/ethylacrylate) (54/46) | A clear faithful proof rendition |
| 5. | Poly(n-butylacrylate/styrene/acrylic acid/acrylonitrile) (45/45/8/2) | A clear faithful proof rendition |
| 6. | Poly(n-butylacrylate/vinylacetate) (80/20) | A clear faithful proof rendition |
| 7. | Poly(vinyl acetate) | Adhesive layer and barrier distorted image |
| 8. | Poly(styrene/butadiene) (90/10) | Adhesive clouded and yellowed |
| 9. | Poly(vinylidene chloride) | Film delaminated from receptor after development |
| 10. | Poly(vinyl chloride) | Changed color hue of pigment, yellowed, mottled pattern in solid color areas |
| 11. | Poly(carboxylated styrene/butadiene) (70/30) | Would not adhere to barrier, yellowed |
| 12. | Poly(vinylacetate/vinyl chloride/vinyl alcohol) | Poor adhesion to receptor, yellowed |
| 13. | Poly(vinylacrylate) | Yellowed |

As can be seen from the data, only thermally laminable acrylate polymers and copolymers performed satisfactorily in the practice of the present invention.

In the foregoing illustration, a cyan color proofing sheet is described. The companion magenta, yellow and black structures (which, together with the cyan sheet, constitute a complete four-color proofing system) are similarly prepared employing the same polyvinylformal resin coating, but incorporating appropriately

EP 0 165 031 B1

colored pigments, for example, "Watchung Red RT 761-D," "Benzidine Yellow YT 564-D," and Cabot "Regal 300 R" carbon black. Pigments are selected and pigment/resin ratios established generally to provide the same color-density as would result from the printing ink of corresponding color being used on the job being proofed. The sheets can be stored in sensitized condition, and then used weeks or months later as successfully as immediately following manufacture. In using the sheets in producing a color proof composite, any desired substrate can be used.

In preparing a color proof composite, the colors are processed individually and consecutively. A sheet of the color represented by the first negative to be proofed, for example yellow is prepared for processing by removing the adhesive protective sheet and laminating the color sheet to the backing sheet. Pressure applied by conventional laminating apparatus with a heated roller is sufficient to achieve lamination through the thermally laminable adhesive. Following lamination the support sheet of polyethylene terephthalate is stripped away. The light sensitive layer now on the backing sheet is contact exposed through the corresponding color separation negative.

The light-imaged backing is then physically developed with a solution of normal propanol-water in a 1:1 volume ratio, brushing and wiping with a soft cloth pad to remove the pigmented resin and unexposed sensitizer layers from the non-image (unexposed) areas to leave the latter clear and colorless. Thereby an image is defined, faithfully representing the reproduction and full color range which would result if the complete platemaking and printing operation (using appropriately matched ink), were carried through with that color separation negative.

A sheet of the second color to be proofed, preferably magenta, is prepared in the same way by removing the adhesive protective sheet and laminating it to the yellow imaged backing sheet. The corresponding color separation negative must now be positioned in exact register with the yellow image. This is commonly provided for by a preregistration of all the separation negatives and the backing sheet by a system of register marks or punches. The light--sensitive layer now on the yellow-imaged backing sheet is exposed and processed, as for the first color. The remaining cyan and black images are thereafter added, in turn, thus faithfully reproducing the four color result which would occur in printing, were printing plates employed prepared from the same color separation negatives.

Certain necessary relationships exist between the elements of the construction just described. Adhesive relationships must be such that, after adhesive lamination to the backing sheet, the release layer will allow stripping away the carrier layer without disrupting the adhesive bond. Failure must not occur at either the adhesive-backing sheet or adhesive-barrier layer bonds. While it is not particularly critical whether release occurs between carrier-layer-release layer or release layer-color layer, release is generally less efficient between two in situ formed layers, resulting in somewhat more likely release between carrier layer and release layer. In this event, it is of importance that the release layer be transparent and soluble in the developing solution.

With regard to the selection of the resin of the color coat and to the solution used to develop the image, reference is again made to U.S. Pat. No. 3,136,637, where numerous organophilic hydrophobic water-insoluble solvent-softenable resinous polymers are disclosed, along with suitable developing solutions. It is therein discussed that upon light-exposure of the structure, a firm in situ bond is formed between the resin and the diazo in the light-struck areas, while permitting the resin to be removed upon light rubbing treatment with the appropriate developing solution. The present invention avails itself of these principles.

Inasmuch as the light-sensitive layer is extremely thin and discontinuous, the color-coat and the barrier layer contact one another in the structure and their inter-relation is important. The bond formed between them (or any intermixing occurring at the interface) must not be such as to prevent the color-coat from being removed in the non-light struck areas during development. As indicated above, whatever natural bond exists is strengthened in situ upon light reaction of the diazo to give a strong bond preventing removal in those areas upon development. It has been found that the desired relation is present where at least a degree of physical incompatability exists between the resins comprising the color and barrier layers.

During the coating operations, best results are obtained where a later applied layer is cast from a solvent which does not dissolve prior layers.

In the preceding example, the color-coating and the diazo resin were applied in separate steps from different solvents.

**Claims**

**1.** A presensitized color-proofing sheet comprising:
  a carrier sheet having a smooth release surface;
  a continuous color coating comprising a layer of a pigmented resinous polymer in clinging

7

engagement with, but not adhesively bonded to the release surface;

a layer of a light-sensitive diazo resin in direct association with the color coating, and

a layer of a thermally-activated adhesive, which sheet is characterised by the combination of:

(a) being negative acting wherein the color coating comprises a pigmented, organophilic, hydrophobic, water-insoluble, resinous polymer softenable and/or partially dissolvable in a solvent developing medium,

(b) having a continuous, water-insoluble, transparent, colorless barrier layer interposed between the diazo resin layer and the thermally-activated adhesive layer, the barrier layer being insoluble in the solvent developing medium,

the diazo resin being directly associated with the color coating either (i) by being incorporated in the color coating to form a single layer, or (ii) by being incorporated in a separate but contiguous layer from the color coating layer, and being soluble in the solvent developing medium, such that the diazo resin becomes insolubilized and firmly bonds the color layer to the barrier layer in the light struck areas upon light exposure of the sheet, the color layer and diazo resin being readily removable from the barrier layer in areas not light exposed, and

(c) the thermally activated adhesive layer comprises a layer of at least one acrylic polymer or copolymer which is laminable at a temperature between 100 and 150˚C at a pressure of 0.29 kg/cm$^2$ in 10 seconds, non-tacky at room temperature, will not discolor or alter its optical density by as much as 0.05 optical density units when exposed to 5 kilowatts of ultraviolet radiation at 417 nanometers at a distance of 10 cm for 2 minutes or during imaging of the sheet, and having no ingredients capable of migrating through the barrier layer and desensitizing the diazo resin, discoloring the pigment, or distorting the optical properties of the other layers.

2. A presensitized sheet as claimed in Claim 1 in which the color coating and the diazo resin are contiguous layers.

3. A presensitized sheet as claimed in Claim 1 in which the color coating and the light-sensitive diazo resin are intermixed in a single layer.

4. A presensitized sheet as claimed in any one of Claims 1 to 3 in which the color coating comprises a pigmented polyvinyl formal resin.

5. A presensitized sheet as claimed in any preceding claim in which a release liner is bonded to the adhesive layer.

6. A presensitized sheet as claimed in any preceding claim in which the acrylic polymer or copolymer comprises poly (n-butyl acrylate) or a copolymer of n-butyl acrylate.

7. A presensitized sheet as claimed in any one of Claims 1 to 5 in which the acrylic polymer or copolymer comprises poly (ethyl acrylate) or a copolymer of ethyl acrylate.

8. A presensitized sheet as claimed in any one of Claims 1 to 5 in which the thermal adhesive comprises a copolymer derived from at least one acrylate selected from the group consisting of n-butyl acrylate and ethyl acrylate and at least one ethylenically unsaturated monomer selected from the group consisting of styrene, acrylic acid, methacrylic acid, acrylic anhydride, and vinyl acetate.

**Revendications**

1. Feuille présensibilisée pour le contrôle des couleurs, comprenant :

un support pelliculaire ayant une surface lisse anti-adhérente ;

un revêtement continu en couleur, comprenant une couche d'un polymère résineux pigmenté, lié par accrochage, mais non par adhérence, à la surface anti-adhérente ;

une couche d'une résine diazoïque photosensible, en association directe avec le revêtement en couleur, et

une couche d'un adhésif thermoactivé, ladite feuille étant caractérisée par la combinaison des points suivants :

(a) elle a un effet négatif, le revêtement en couleur comprenant un polymère résineux, insoluble dans l'eau, hydrophobe, organophile, pigmenté, pouvant être assoupli et/ou partiellement dissous dans un milieu de développement à base de solvant,

(b) elle possède une couche barrière incolore, transparente, insoluble dans l'eau, continue, intercalée entre la couche de résine diazoïque et la couche adhésive thermoactivée, la couche barrière étant insoluble dans le milieu de développement à base de solvant,

la résine diazoïque étant directement associée au revêtement en couleur,

(i) ou bien en étant incorporée dans le revêtement en couleur pour former une couche unique,

(ii) ou bien en étant incorporée dans une couche distincte de la couche de revêtement en couleur mais contiguë à cette dernière, et en étant soluble dans le milieu de développement à base de solvant,

de telle sorte que la résine diazoïque devienne insolubilisée et fixe fermement la couche en couleur à la couche barrière dans les zones recevant la lumière, après exposition de la feuille à la lumière, la couche en couleur et la résine diazoïque pouvant être facilement enlevées de la couche barrière dans les zones non exposées à la lumière, et

(c) la couche adhésive thermoactivée comprend une couche d'au moins un polymère ou copolymère acrylique pouvant être contrecollée à une température comprise entre 100 et 150°C sous une pression de 0,29 kg/cm$^2$ en 10 secondes, qui est non poisseuse à la température ambiante, qui ne change pas de couleur ou ne modifie pas sa densité optique de plus de 0,05 unité de densité optique quand elle est exposée à un rayonnement ultraviolet de 5 kilowatts à 417 nanomètres à une distance de 10 cm pendant 2 minutes ou pendant la formation d'une image sur la feuille, et qui ne comporte aucun ingrédient capable de migrer à travers la couche barrière et de désensibiliser la résine diazoïque, de modifier la couleur du pigment ou de modifier les propriétés optiques des autres couches.

2. Feuille présensibilisée selon la revendication 1, dans laquelle le revêtement en couleur et la résine diazoïque sont des couches contiguës.

3. Feuille présensibilisée selon la revendication 1, dans laquelle le revêtement en couleur et la résine diazoïque photosensible sont mélangés en une seule couche

4. Feuille présensibilisée selon l'une quelconque des revendications 1 à 3, dans laquelle le revêtement en couleur comprend une résine de polyvinylformal pigmentée.

5. Feuille présensibilisée selon l'une quelconque des revendications précédentes, dans laquelle un revêtement antiadhérent est fixé à la couche adhésive.

6. Feuille présensibilisée selon l'une quelconque des revendications précédentes, dans laquelle le polymère ou copolymère acrylique comprend le poly(acrylate de n-butyle) ou un copolymère d'acrylate de n-butyle.

7. Feuille présensibilisée selon l'une quelconque des revendications 1 à 5, dans laquelle le polymère oú copolymère acrylique comprend le poly(acrylate d'éthyle) ou un copolymère d'acrylate d'éthyle.

8. Feuille présensibilisée selon l'une quelconque des revendications 1 à 5, dans laquelle l'adhésif thermique comprend un copolymère dérivant d'au moins un acrylate choisi parmi l'ensemble comprenant l'acrylate de n-butyle et l'acrylate d'éthyle et au moins un monomère à insaturation éthylénique choisi parmi l'ensemble comprenant le styrène, l'acide acrylique, l'acide méthacrylique, l'anhydride acrylique et l'acétate de vinyle.

**Patentansprüche**

1. Vorsensibilisiertes Blatt zur Farbprüfung umfassend:

ein Trägerblatt, das eine glatte Trennfläche aufweist;

eine kontinuierliche Farbschicht, die eine Schicht eines pigmentierten harzartigen Polymers umfaßt, die in innigem haftendem Kontakt mit der Trennfläche steht aber nicht an sie geklebt ist;

eine Schicht aus einem lichtempfindlichem Diazoharz, die mit der Farbschicht direkt assoziiert ist, und eine Schicht eines thermisch aktivierten Klebstoffs, wobei das Blatt durch die Kombination folgender Merkmale gekennzeichnet ist :

(a) es wirkt negativ, wobei die Farbschicht ein pigmentiertes, organophiles, hydrophobes, wasserunlösliches harzartiges Polymer umfaßt, das in einem Lösungsmittel-Entwicklungsmedium erweichbar und/oder teilweise löslich ist,

(b) es weist eine kontinuierliche, wasserunlösliche, transparente, farblose Trennschicht auf, die zwischen der Schicht aus Diazoharz und der Schicht des thermisch aktivierten Klebstoffs liegt, wobei die Trennschicht in dem Lösungsmittel-Entwicklungsmedium unlöslich ist,

wobei das Diazoharz dadurch direkt mit der Farbschicht assoziiert ist, indem es entweder (i) in die Farbschicht inkorporiert ist, wodurch eine einzige Schicht ausgebildet wird, oder (ii) in eine getrennte, aber zur Farbschicht benachbarte Schicht inkorporiert ist und in dem Lösungsmittel-Entwicklungsmedium löslich ist, wobei das Diazoharz bei Belichtung des Blattes unlöslich wird und die Farbschicht fest an die Trennschicht in den Bereichen bindet, die bei Belichtung von Licht getroffen werden, wobei die Farbschicht und das Diazoharz leicht von der Trennschicht in den Bereichen entfernt werden können, die nicht belichtet worden sind, und

(c) die Schicht des thermisch aktivierten Klebestoffs umfaßt eine Schicht von mindestens einem Acrylpolymer oder -copolymer, die bei einer Temperatur zwischen 100 und 150°C bei einem Druck von 0,29 kg/cm$^2$ in 10 Sekunden laminiert werden kann, die bei Raumtemperatur nicht klebrig ist, die sich nicht verfärbt oder ihre optische Dichte nur um weniger als 0,05 optische Dichteeinheiten verändert, wenn sie aus einer Entfernung von 10 cm 2 Minuten lang mit 5 kW einer ultravioletten Strahlung von 417 nm belichtet wird oder während des Bildaufbaus des Blattes, und die keine Inhaltsstoffe aufweist, die zur Wanderung durch die Trennschicht und Desensibilisierung des Diazoharzes, Verfärbung des Pigmentes oder Verzerrung optischer Eigenschaften der anderen Schichten in der Lage sind.

2.  Vorsensibilisiertes Blatt nach Anspruch 1, in dem die Farbschicht und das Diazoharz benachbarte Schichten sind.

3.  Vorsensibilisiertes Blatt nach Anspruch 1, in dem die Farbschicht und das lichtempfindliche Diazoharz in einer einzigen Schicht vermischt sind.

4.  Vorsensibilisiertes Blatt nach einem der Ansprüche 1 bis 3, in dem die Farbschicht ein pigmentiertes Polyvinyl-Formaldehydacetalharz umfaßt.

5.  Vorsensibilisiertes Blatt nach einem der vorstehenden Ansprüche, in dem eine Abtrennschicht mit der Klebschicht verbunden ist.

6.  Vorsensibilisiertes Blatt nach einem der vorstehenden Ansprüche, in dem das Acrylpolymer oder -copolymer Poly(n-butylacrylat) oder ein Copolymer von n-Butylacrylat umfaßt.

7.  Vorsensibilisiertes Blatt nach einem der Ansprüche 1 bis 5, indem das Acrylpolymer oder -copolymer Poly(ethylacrylat) oder ein Copolymer von Ethylacrylat umfaßt.

8.  Vorsensibilisiertes Blatt nach einem der Ansprüche 1 bis 5, in dem der Thermoklebstoff ein Copolymer umfaßt, das aus mindestens einem Acrylat, nämlich n-Butylacrylat oder Ethylacrylat und mindestens einem ethylenisch ungesättigten Monomer, nämlich Styrol, Acrylsäure, Methacrylsäure, Acrylanhydrid oder Vinylacetat hergestellt worden ist.